# EUROPEAN PATENT APPLICATION

(11) **EP 1 768 166 A2**
(43) Date of publication of application: **28.03.2007**
(21) Application number: 06254901.9
(22) Date of filing: 22.09.2006
(51) Int. Cl.: H01L 21/00

(54) **Method of resin-seal molding electronic component and apparatus therefor**

(30) Priority: 27.09.2005 JP 2005280294
(71) Applicant: Towa Corporation, Kyoto 6018105 (JP)
(72) Inventor: Bandoh, Kazuhiko, c/o Towa Corporation, Kyoto-shi, Kyoto 601-8105 (JP)
(74) Representative: Roberts, David Leslie

(57) **Abstract**

A mold (110) for resin-seal-molding an electronic component is constituted by a first mold (111) and a second mold (112). A plurality of mold structure units (molds 110) are arranged as stacked, wherein a substrate supplying portion (substrate supply-set surface 113) for supplying a single before-resin-seal-molding substrate (400) having an electronic component mounted thereon is provided at a mold face (PL) of the molds. Further, a clamp mechanism (press frame mechanism 130) for simultaneously applying clamping pressure to each of the plurality of mold structure units (molds 110) arranged as stacked. With this structure, the overall structure of the mold (110) for resin-seal-molding an electronic component mounted on the substrate (400) can be simplified. Additionally, resin flash formation on the substrate surface due to variation in the thicknesses of the substrates (400) when resin-seal-molding the electronic component is prevented.

## Description

This nonprovisional application is based on Japanese Patent Application No. 2005-280294 filed with the Japan Patent Office on September 27, 2005, the entire contents of which are hereby incorporated by reference.

### BACKGROUND OF THE INVENTION

### Field of the Invention

The present invention relates to a method of seal-molding an electronic component of a relatively small size such as a semiconductor chip by a resin material, and to an apparatus for resin-seal-molding an electronic component used for implementing the method.

### Description of the Background Art

Recently, an improvement has particularly been required in the function of a semiconductor package wherein an electronic component of a relatively small size such as a semiconductor chip is seal-molded by a resin material (hereinafter simply referred to as a semiconductor package). Specifically, for example a so-called MAP type large substrate has strongly been required to have higher integration, higher reliability, and further compactness; that is, to be lighter, thinner, shorter, and smaller.

Accordingly, when molding a semiconductor package, it is necessary to perform resin-seal-molding so that the structure thereof becomes compact as much as possible, in a state where the quality of the highly integrated component to be resin-seal-molded is maintained.

In such resin-seal-molding, in order to maintain the quality of the semiconductor package that is the component to be resin-seal-molded, it is important to improve adhesion (or contact) between the resin material for sealing the electronic component and the lead frame or substrate to which the electronic component is mounted (hereinafter simply referred to as a substrate). However, this also causes adhesion between the resin material and a surface of a mold for resin molding to be increased. Therefore, there is a problem that mold release characteristics in removing the molded product from the mold after the resin-seal-molding are deteriorated and the molded product cannot be released efficiently.

Additionally, for example if molded product releasing means for releasing the molded product by forcibly ejecting the molded product with an ejector pin or the like is employed, coupled with the compactness of the molded product, there is a problem that the molded product body (resin-seal-molded body) may be damaged and a crack may occur, or it may be broken and its quality may be degraded.

Further, when an ejector pin mechanism such as described above is incorporated into a resin-molding mold, there is a problem that the mold structure becomes complicated and the overall durability is impaired.

Still further, when a mechanism for melting the resin material or a mechanism for transferring the molten resin material is incorporated inside a mold, not only the mold structure becomes complicated but also there is a problem that resin-seal-molding conditions become limited based on the complicated mold structure.

In the following, conventional means for resin-seal-molding an electronic component is described.

First, it is widely known to provide a prescribed surface treatment on a mold cavity surface and the like in order to improve mold release characteristics in removing the molded product from the mold. However, the effect of the surface treatment is not uniform, and it is less durable. Further, in resin-seal-molding an electronic component, a thermosetting resin material such as epoxy resin is mainly used, and additionally, a large substrate is used. Under these circumstances, practically, the conventional ejector pin mechanism has been employed in combination, for surely and efficiently releasing the molded product.

Commonly, a conventional mold surface is provided with a recess (a clearance of a prescribed depth provided to a parting line (PL) face of a mold, as corresponding to the thickness of a substrate) for insert-setting a substrate. This recess invites the following problems.

The thickness of each site of a large substrate is not uniform, i.e., the thickness varies among each site. Additionally, it is common to simultaneously insert-set a large number of such large substrates to a mold surface. Therefore, clamping state is not uniform among the large substrates even if the large substrates are simultaneously applied with mold-clamping pressure. This sometimes causes part of the resin material to flow into between each of the large substrates and the mold surfaces, resulting in formation of resin flash on the substrate surface and on the mold surface. Conversely, if each of the substrates is applied with the clamping pressure so as to prevent the resin flash formation, there is an adverse effect that semiconductor elements or interconnections on the substrates are damaged if the clamping pressure is excessive.

Thus, the variation in the thicknesses of substrates has been a factor of significant degradation in the quality of a molded product.

In a conventional mold structure, normally, a pot (a portion for plasticizing a resin material) is provided inside the mold. On the aforementioned mold face (parting line PL face) of the mold, a resin-molding cavity and a resin path for transferring the molten resin material constituted of a cull, a runner and the like for implementing communication between the cavity and the pot are formed as recesses. Thus, on the mold face, the portion for insert-setting the substrate, the pot portion, the resin path portion and the like are provided as recesses. Based on such a mold structure, the following problem on the resin-seal-molding arises.

That is, in this type of resin-seal-molding, prevention of formation of resin flash on the surface of substrate is regarded as the most important matter. Therefore, for example for the purpose of efficient application of clamping pressure to the substrate, clamping is often set so that the clamping pressure is higher in the portion for insert-setting the substrate than in the pot portion and the resin path portion. In resin-seal-molding, the resin pressure on the molten resin material acts to open the mold face of the mold. Accordingly, the molten resin material in the pot or in the resin path in the state described above is prone to enter a gap on the mold face than the material in other sites because of the resin pressure.

As a result, such an adverse effect arises that a thin resin flash is formed on the mold face near the pot portion and the resin path portion. Setting of resin-seal-molding conditions, setting of the mold surface shape or manufacturing of the mold for preventing such an adverse effect is extremely cumbersome. In addition, considering for example setting of resin-seal-molding conditions specific to the resin material used in the resin-seal-molding, there is a problem that the overall working efficiency is significantly impaired. Further, such a thin resin flash is difficult to be completely removed in the cleaning step. Thus, there is a problem that it mixes into the molten resin material in the next resin-seal-molding, resulting in a defective product. There is also a problem that the cured resin flash causes failure in clamping in the clamping step.

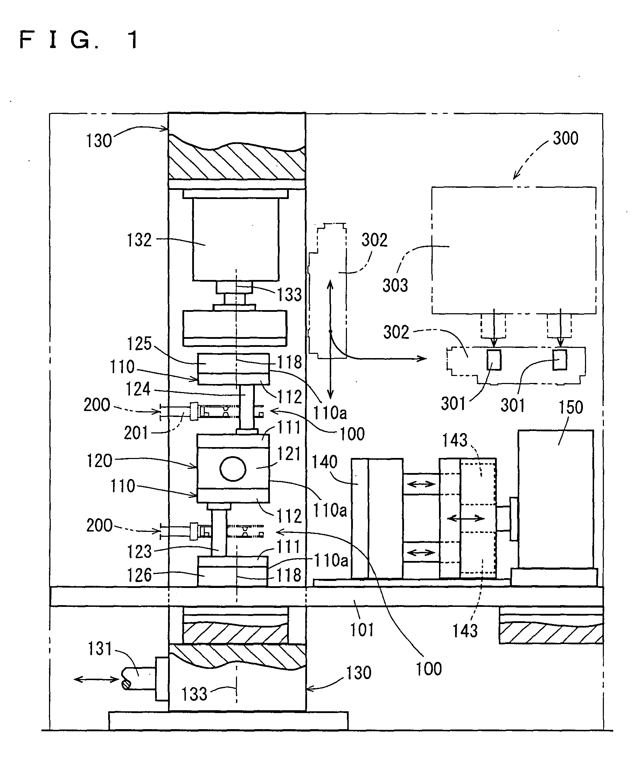

For solving the aforementioned problem of variation in the thickness of a substrate, there is a proposal of a resin-seal-molding apparatus employing a so-called floating structure, wherein a substrate supporting member (pressing member) is supported by an elastic member in a recess (sliding hole) for insert-setting a substrate (sheet-like member) (for example, see Japanese Patent Laying-Open No. 11-126787 (page 7, Fig. 1)).

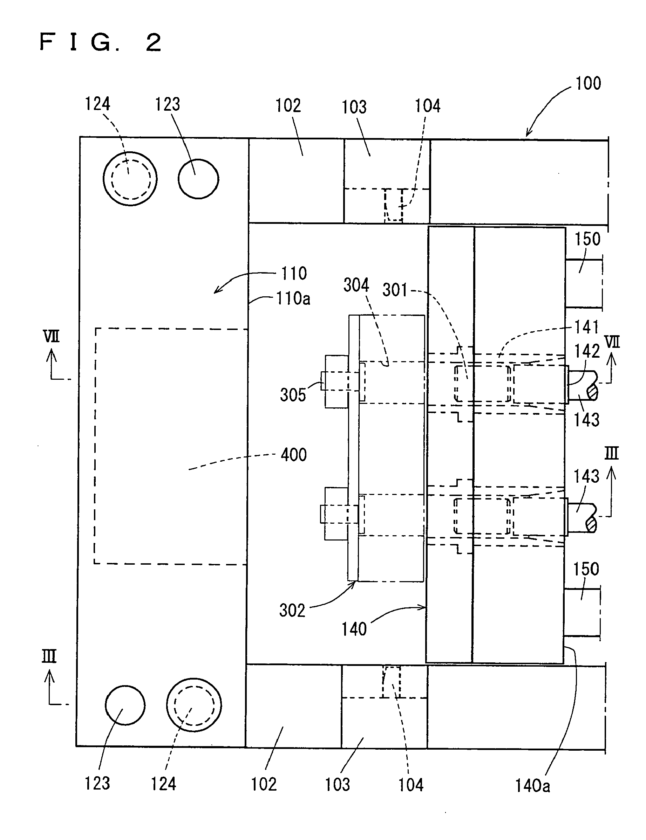

There is also a proposal of a resin-seal-molding apparatus having a configuration wherein the aforementioned mechanism for plasticizing the resin material (injection cylinder), the mechanism for transferring plasticized resin material (press piston) and the like are arranged external to the mold (for example, see Japanese Patent Laying-Open No. 59-052842 (page 5, Fig. 2)). According to this configuration, there is an advantage of simplifying the mold structure by arranging the mechanism for melting the resin externally to the mold.

Among the conventional resin-seal apparatuses wherein many substrates are mounted on one mold structure to carry out the resin-seal-molding, the apparatus employing the floating structure for solving the aforementioned problem of variation in a substrate (Japanese Patent Laying-Open No. 11-126787, (page 7, Fig. 1) not only introduces further complication into a general mold structure, but also involves a problem of cumbersome mold manufacturing associated with an increase in costs. The following problem has also been pointed out. Works of adjusting elastic pressing force on each site of the substrate, works of adjusting elastic pressing force when performing resin-seal-molding to other type of substrate having different thickness and the like are cumbersome. Additionally, when resin-seal-molding electronic components while many substrates are supply-set to the mold face (PL face), coupled with the fact that each substrate varies in thickness, works such as adjusting the elastic pressing force on each substrate is substantially impossible. Further, works such as mold maintenance is very cumbersome. Accordingly, it is difficult to bring the resin-seal-molding apparatus having the floating structure into practical use.

In the resin-seal-molding apparatus having a configuration wherein the aforementioned mechanism for melting the resin material, the mechanism for transferring molten resin material and the like are arranged external to the mold (Japanese Patent Laying-Open No. 59-052842, (page 5, Fig. 2)), the mechanism for melting the resin material and the like are simply arranged externally to the mold. The structure such as a so-called cull portion, a resin path portion communicating with the cull portion, the gate portion and the like, which are generally employed as a mold structure, are arranged inside the mold. Thus, this site of the mold structure is the same as in the conventional mold structure. The basic mold structure is therefore not simplified. Further, the amount of resin cured in this site (the amount of resin to be wasted) is great and is not economical.

### SUMMARY OF THE INVENTION

An object of the present invention is to provide a method of resin-seal-molding an electronic component and an apparatus therefor, which can simplify a mold structure, and solve the problems in a conventional method wherein a large number of substrates are mounted on one mold structure to perform resin-seal-molding.

A method of resin-seal-molding an electronic component according to the present invention includes: a mold-structure-unit-preparing step of preparing at least one mold structure unit for resin-seal-molding an electronic component, the mold structure unit being provided to freely open and close; a before-resin-seal-molding-substrate-supplying step of supplying a single before-resin-seal-molding substrate having an electronic component mounted thereon between mold surfaces in the mold structure unit; a clamping step of, when closing the mold surfaces to clamp, inserting the electronic component on the before-resin-seal-molding substrate and a prescribed surrounding portion into a molding cavity provided between the mold surfaces, and applying in this state a prescribed clamping pressure from the mold surface to a surface of the substrate; a resin-seal-molding step of, after the clamping step, filling the cavity with a molten resin material to seal by the molten resin material the electronic component and the prescribed surrounding portion being inserted into the cavity, and to bring a resin-seal-molded body formed by cure of the resin material and the substrate into close contact with each other to be integrated; and a resin-seal-molded-substrate-removing step of, after the resin-seal-molding step, opening the mold surfaces to remove the resin-seal-molded substrate.

In the method of resin-seal-molding an electronic component according to the present invention, preferably, in the mold-structure-unit-preparing step, a plurality of the mold structure units are arranged as stacked, and further, in the clamping step, the clamping pressure is simultaneously applied to each of the plurality of mold structure units arranged as stacked.

An apparatus for resin-seal-molding an electronic component according to the present invention has each means for implementing the method of resin-seal-molding an electronic component.

According to the method of resin-seal-molding an electronic component of the present invention, only one substrate is set to one mold structure unit. Therefore, it is not necessary to use an apparatus for resin-seal-molding an electronic component with a mold of a complicated structure. Thus, the operability or workability of the apparatus can be improved. This facilitates practical application of the method and the apparatus.

Further, according to the method of resin-seal-molding an electronic component of the present invention, resin flash formation on the substrate surface can efficiently and surely be prevented without being affected by the variation in the thicknesses of substrates. Therefore, a resin-seal-molded product of an electronic component of high quality and high reliability can be molded.

According to the method of resin-seal-molding an electronic component of the present invention, an apparatus having a simple structure can be employed. Therefore, the overall apparatus can be made small. Further, the maintenance works of the mold can be carried out easily.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a partially cutaway vertical cross-sectional front view showing the overview of a resin-seal-molding apparatus for implementing a method of resin-seal-molding an electronic component according to the present invention.
Fig. 2 is a partially cutaway plan view schematically showing substantial part of a resin-seal-molding portion in the resin-seal-molding apparatus in Fig. 1.
Fig. 3 is a partially cutaway cross-sectional view of the resin-seal-molding portion corresponding to Fig. 2, being a cross-sectional view along line III-III in Fig. 2, showing a mold-open state thereof, and a supply state of a before-resin-seal-molding substrate and a resin material.
Fig. 4 is a partially cutaway cross-sectional view of the resin-seal-molding portion corresponding to Fig. 3, showing a clamping state thereof and a state in which the resin material is supplied inside a pot.
Fig. 5 is a partially cutaway cross-sectional view of the resin-seal-molding portion corresponding to Fig. 4, showing a state of pressurizing and transferring the resin material in the pot to a mold cavity.
Fig. 6 is a partially cutaway plan view of the resin-seal-molding portion corresponding to Fig. 5, showing a state where a pot block is joined with the side position of the mold.
Fig. 7 is a partially cutaway cross-sectional view of the resin-seal-molding portion corresponding to Fig. 5, being a cross-sectional view along line XII-XII in Fig. 2.
Fig. 8 is a partially cutaway cross-sectional view of the resin-seal-molding portion corresponding to Fig. 3, showing a state of removing a resin-seal-molded substrate.
Figs. 9-11 are explanatory views of a method for supplying and setting a before-resin-seal-molding substrate to a prescribed position on a mold surface.

### DESCRIPTION OF THE PREFERRED EMBODIMENTS

A method of resin-seal-molding an electronic component according to the present invention includes: a mold-structure-unit-preparing step of preparing at least one mold structure unit for resin-seal-molding an electronic component, the mold structure unit being provided to freely open and close; a before-resin-seal-molding-substrate-supplying step of supplying a single before-resin-seal-molding substrate having an electronic component mounted thereon between mold surfaces in the mold structure unit; a clamping step of, when closing the mold surfaces to clamp, inserting the electronic component on the before-resin-seal-molding substrate and a prescribed surrounding portion into a molding cavity provided between the mold surfaces, and applying in this state a prescribed clamping pressure from the mold surface to a surface of the substrate; a resin-seal-molding step of, after the clamping step, filling the cavity with a molten resin material to seal by the molten resin material the electronic component and the prescribed surrounding portion being inserted into the cavity, and to bring a resin-seal-molded body formed by cure of the resin material and the substrate into close contact with each other to be integrated; and a resin-seal-molded-substrate-removing step of, after the resin-seal-molding step, opening the mold surfaces to remove the resin-seal-molded substrate.

To a mold surface in a conventional mold structure, a plurality of substrates are supplied and each of the substrates varies in thickness. Thus, there is a basic problem that clamping pressure cannot be applied to individual substrates uniformly and efficiently. For example, when each substrate is applied with clamping pressure in order to prevent resin flash formation on each substrate surface, an adverse effect of damaging semiconductor elements and interconnections on each substrate is invited if clamping pressure is excessive. Conversely, if the clamping pressure is not enough, an adverse effect of failing to uniformly and surely prevent resin flash formation on each substrate is invited.

However, according to a resin-seal-molding method of the present embodiment, a single substrate is supplied to the mold surface. Therefore, as compared to a method wherein a plurality of substrates are supplied to the mold surface, clamping pressure can be applied to the single substrate uniformly. That is, even when substrates vary in their thicknesses, setting and/or adjustment of the clamping pressure to each of the substrates can be carried out very easily.

Thus, even when the substrates supplied to the mold surface vary in their thicknesses, without being affected thereby, it becomes possible to prevent formation of resin flash on the substrate surface efficiently and surely. Therefore, a resin-seal-molded product of an electronic component of high quality and high reliability can be formed.

It should be noted that, as described above, even with the substrates of the identical type, the substrates may vary in their thicknesses. According to the method of the present embodiment, without being affected by such variation in thicknesses of substrates, it becomes possible to apply clamping pressure to the substrate uniformly and efficiently.

When performing resin-seal-molding of substrates of a different type, conventionally, it has been necessary to provide a recess for supply-setting or the like corresponding to the thicknesses of those substrates. The substrates of the different type vary in their thicknesses, and thus involve the aforementioned problem. However, according to the present invention, it becomes possible to apply clamping pressure uniformly and efficiently also to each of the substrates of a different type. Thus, as described above, the problem of variation in the thicknesses of substrates of one type can appropriately and easily be addressed. Further, when there is a change in the resin-seal-molded product and therefore resin-seal-molding of substrates of a different type is to be carried out, variation in the thicknesses due to the change of the substrate and variation in the thicknesses of the changed substrate can both appropriately and easily be addressed.

In the method of resin-seal-molding an electronic component according to the present invention, preferably, in the mold-structure-unit-preparing step, a plurality of the mold structure units are arranged as stacked. Further, in the clamping step, the clamping pressure is simultaneously applied to each of the plurality of mold structure units arranged as stacked.

According to such a method of the present embodiment, the size of the apparatus in the stack arrangement direction is increased corresponding to the size of the plurality of mold structure units to be arranged as stacked. It is noted that the clamping pressure is substantially the same as that required for clamping in the case of a single substrate, since the plurality of substrates are arranged as stacked.

Accordingly, there is no necessity of increasing the size of the mold and apparatus corresponding to the increasing mold area corresponding to the number of substrate being supply-set, or necessity of setting high clamping pressure, as in the conventional mold structure wherein a plurality of before resin-seal-molding substrates are supply-set between identical mold surfaces. It is not necessary to set the clamping pressure to be gradually high corresponding to an increase in the number of the plurality of mold structure units. Therefore, the whole form of the mold and the apparatus can be made smaller, as compared with a conventional mold structure. Further, electronic components in the respective substrates can simultaneously be resin-seal-molded under the identical molding condition. Therefore, uniform products of high quality and high reliability can be manufactured highly efficiently.

An apparatus for resin-seal-molding an electronic component of the present embodiment allows an electronic component mounted on a substrate to be inserted into a molding cavity provided to a mold for resin-seal-molding an electronic component. The apparatus closes the mold surface and applies a clamping pressure by the mold to the substrate surface from the mold. The apparatus allows the cavity to be filled with a molten resin material in this clamping state. Thus, the apparatus seals the electronic component inserted into the cavity by the resin material. In the apparatus, a plurality of mold structure units, wherein a plurality of substrate supply portions are provided to the mold face (PL face) of the mold for resin-seal-molding, are arranged as stacked. The apparatus has a clamping mechanism applying the clamping pressure to the mold structure unit arranged as stacked.

According to such an apparatus of the present embodiment, the size of the apparatus in the stack arrangement direction is increased corresponding to the size of the plurality of mold structure units to be arranged as stacked. It is noted that the clamping pressure is substantially the same as that required for clamping in the case of a single substrate, since the plurality of substrates are arranged as stacked.

Accordingly, there is no necessity of increasing the size of the mold and apparatus corresponding to the increasing mold area corresponding to the number of substrate being supply-set, or necessity of setting high clamping pressure, as in the conventional mold structure wherein a plurality of before resin-seal-molding substrates are supply-set between identical mold surfaces. It is not necessary to set the clamping pressure to be gradually high corresponding to an increase in the number of the plurality of mold structure units. Therefore, the whole form of the mold and the apparatus can be made smaller, as compared with a conventional mold structure. Further, electronic components in the respective substrates can simultaneously be resin-seal-molded under the identical molding condition. Therefore, uniform products of high quality and high reliability can be manufactured highly efficiently.

In the following, a method of resin-seal-molding an electronic component and an apparatus therefor according to an embodiment of the present invention will be described referring to the drawings.

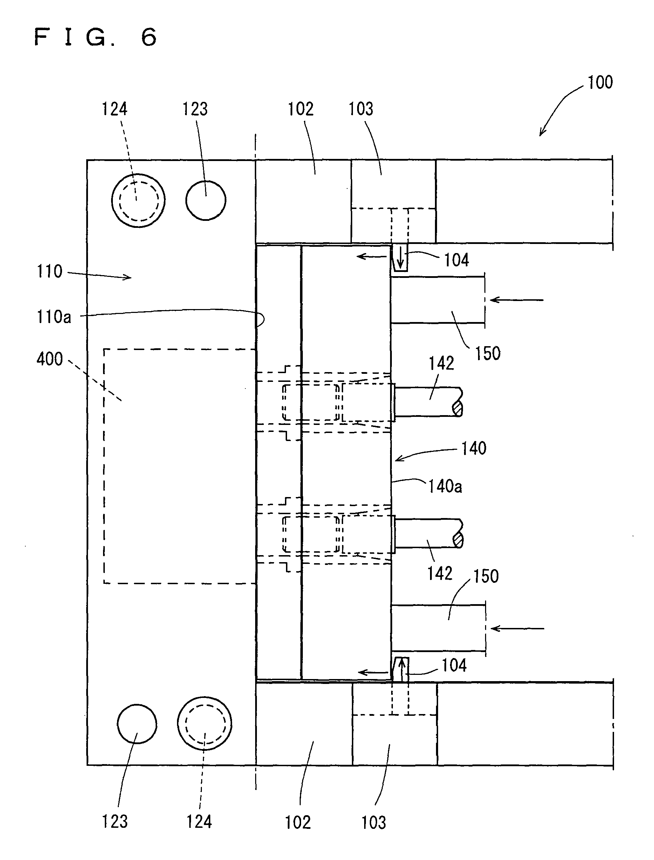

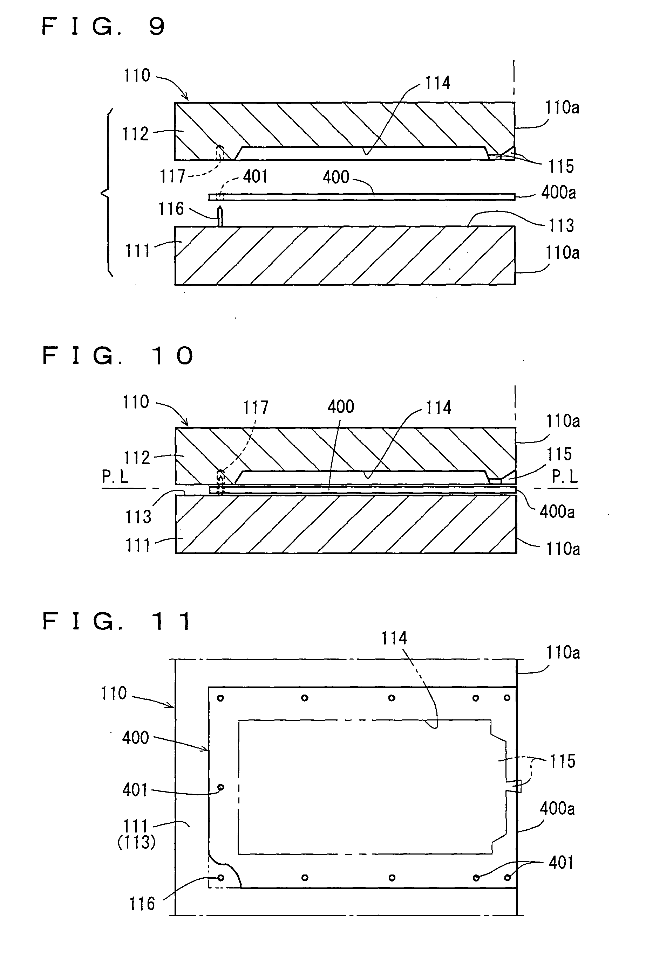

Fig. 1 schematically shows a configuration of a resin-seal-molding apparatus for implementing the resin-seal-molding method of the present invention, and Figs. 2-8 schematically show substantial part of a resin-seal-molding portion in the resin-seal-molding apparatus. Figs. 9-11 are explanatory views of a method of supply-setting a before-resin-seal-molding substrate to a prescribed position on the mold surface.

### First Embodiment

Fig. 1 schematically shows an overall configuration of a resin-seal-molding apparatus.

The resin-seal-molding apparatus includes a resin-seal-molding portion 100 for resin-seal-molding an electronic component on a substrate, a substrate supply-remove mechanism 200 for carry-supplying the before-resin-seal-molding substrate to a prescribed position, which will be described later, of the resin-seal-molding portion and for removing and carrying the resin-seal-molded substrate out of the resin-seal-molding portion, and a resin material carry-supply mechanism 300 for carry-supplying the resin material to a prescribed position, which will be described later, of the resin-seal-molding portion.

Resin-seal-molding portion 100 includes mold 110 for resin-seal-molding an electronic component, a mold open-close mechanism 120 for opening and clamping the mold, a press frame mechanism 130 for applying prescribed clamping pressure to mold 110 in a state where mold 110 is clamped, a pot block 140 for supplying a resin material arranged beside mold 110, and a mechanism 150 for reciprocate driving the pot block arranged so that pot block 140 is freely joined and separated with respect to side position 110a of the mold intersecting perpendicularly with mold face (PL face) of mold 110.

Mold 110 includes at least one set of mold structure unit. The drawing shows an example of a configuration in which two sets of mold structure units each constituted of a first mold 111 and a second mold 112 are arranged as stacked in the vertical direction.

To the mold surface, that is, the mold face (PL face) of first mold 111, as shown in Figs. 9-11, a supply-set surface 113 for supplying substrate 400 is provided. Supply-set surface 113 implements a portion for supplying a single substrate for supply-setting one substrate 400 with an electronic component (not shown) mounted thereon.

That is, to supply-set surface 113 for substrate 400 in the aforementioned one set of mold structure unit, only one substrate 400 is supplied and set.

Further, to supply-set surface 113 for supplying substrate 400, a step or the like for positioning the substrate is not provided, which have been provided as a recessed shape in a conventional mold surface.

Accordingly, supply-set surface 113 for supplying the substrate is formed in a flat shape. To the mold surface of second mold 112 arranged opposite to supply-set surface 113 of first mold 111, a resin-molding cavity 114 is provided.

Reference number 115 in Figs. 9-11 denotes a transfer path for a molten resin material. One end thereof is formed to communicate with cavity 114, while the other end thereof is formed to communicate with side position 110a of mold face (PL face).

Reference number 116 denotes a positioning pin provided at a prescribed position on the mold surface (substrate supply-set surface 113) of first mold 111. Similarly, reference number 117 denotes a pin hole formed at each position on second mold 112 opposite to each positioning pin 116. Positioning pin 116 and pin hole 117 show one example of means for supply-setting before-resin-seal-molding substrate 400 to a prescribed position on substrate supply-set surface 113.

Specifically, when supply-setting substrate 400 to substrate supply-set surface 113, substrate 400 can efficiently and surely be supplied to a prescribed position on substrate supply-set surface 113 if a positioning hole 401 provided to substrate 400 and positioning pin 116 are engaged with each other. Further, performing clamping where two molds (111, 112) are closed in this state, each positioning pin 116 of first mold 111 is fitted into each pin hole 117 of second mold 112. Thus, as shown in Fig. 10, substrate 400 is surely supply-set to substrate supply-set surface 113.

It is noted that the prescribed position on substrate supply-set surface 113 to which substrate 400 is supply-set means a position where end portion 400a of substrate 400 and side position 110a of the mold are positioned on the identical plane.
Formation of a gap between them is prevented by positioning end portion 400a of the substrate and side position 110a of the mold on the identical plane in clamping. Thus, in the resin-seal-molding step, such an adverse effect can be prevented that the molten resin material with which the gap is filled remains and cure-molded. Further, such an adverse effect can efficiently and surely be prevented that part of the molten resin material in the gap flows onto the bottom surface of the substrate and resulting in formation of a resin flash on the substrate surface.

At cavity 114 of second mold 112, transfer path 115 for the molten resin material is formed. Therefore, an air vent (not shown) communicating with cavity 114 may be formed at a position opposite to transfer path 115 relative to cavity 114. Thus, when injecting the molten resin material into cavity 114 which will be described later, residual air in cavity 114 can positively be evacuated to the outside through the air vent by the effect of injection of the molten resin material.

Mold open-close mechanism 120 is a mechanism for simultaneous mold-opening or clamping of the two sets of mold structure units (molds 110) arranged as stacked (overlaid) in the vertical direction. As this mechanism, an appropriate fluid power mechanism, crank mechanism or other mechanic and electric vertical drive mechanism can be employed. The drawing shows a mold open-close mechanism where a rack-pinion mechanism is employed.

Body 121 of the mold open-close mechanism is provided with a pinion gear 122 provided to be rotated by a normal/reverse rotation drive motor (not shown), and two rack gears (123, 124) meshing with pinion gear 122 and move reversely to each other in the vertical direction based on the normal and reverse rotation of pinion gear 122.

One rack gear 123 has its lower end portion fixed to a machine frame 101 fixed at a lower position, and has its upper end portion meshed with pinion gear 122. On the other hand, the other rack gear 124 has its lower end portion meshed with pinion gear 122, and has its upper end portion fixed to a mold mounting block 125 arranged above.

One set of mold structure unit (mold 110) constituted of first mold 111 and second mold 112 is provided to each position of the upper surface and the lower surface of mold open-close mechanism body 121.

In the mold structure unit provided to the upper surface position of mold open-close mechanism body 121, first mold 111 thereof is fixed to the upper surface of mold open-close mechanism body 121, while second mold 112 is fixed to the lower surface of mold mounting block 125 arranged above. On the other hand, in the mold structure unit provided to the lower surface position of mold open-close mechanism body 121, second mold 112 thereof is fixed to the lower surface of mold open-close mechanism body 121, while first mold 111 is fixed to the upper surface of mold mounting block 126 provided to machine frame 101.

Therefore, according to such a configuration, by normally and reversely rotating pinion gear 122, simultaneous mold-opening and clamping of first mold 111 and second mold 112 in each of the two sets of mold structure units (molds 110) arranged as stacked in the vertical direction can be achieved.

Mold open-close mechanism 120 in the present embodiment is capable of simultaneously mold-open or clamp the two sets of mold structure units (molds 110) arranged as stacked in the vertical direction by rotating pinion gear 122 by a motor and moving rack gears (123, 124) meshed with pinion gear 122 reversely to each other in the vertical direction. The mold open-close mechanism of the present invention is not limited to such a mold open-close mechanism, and other configuration can be employed. That is, the mold open-close mechanism of the present invention may only be a mechanism that can simultaneously mold-open or clamp two sets of mold structure units (molds 110) arranged as stacked in the vertical direction. For example, as a drive source thereof, the aforementioned appropriate fluid power mechanism, crank mechanism or other mechanic and electric vertical drive mechanism can be employed. Further, a configuration may be employed wherein such a drive source moves second mold 112 itself (or the rack gear) vertically, and the two sets of mold structure units (molds 110) arranged as stacked in the vertical direction can simultaneously mold-opened or clamped in association therewith.

Press frame mechanism 130 is for applying prescribed clamping pressure to mold 110 in a state where mold 110 is clamped.

Press frame mechanism 130 is provided so that it can reciprocally move along machine frame 101 by an appropriate reciprocate drive mechanism 131. Press frame mechanism 130 is provided with press means 132 using electric, hydraulic, mechanic and other appropriate pressing mechanism.

Therefore, according to such a configuration, by reciprocate drive mechanism 131, such an alignment adjustment can be achieved that a press center position 133 of press means 312 in press frame mechanism 130 is moved to a position where it matches with a center position 118 of mold 110. Additionally, the pressing force of press means 132 can efficiently and surely be applied to center position 118 of clamped mold 110. Thus, in the mold clamping, the mold clamping pressure of the press means 132 applied to each of the mold structure units (molds 110) arranged as stacked is simultaneously and uniformly applied to each of the mold structure units.

It is noted that center position 118 of mold 110 refers to the center position of mold 110 itself. In the present invention, as described above, it is one substance that substrate end portion 400a and side position 110a of the mold are positioned on an identical plane (see Fig. 9). Accordingly, the center position of mold 110 in this case means the center position of the substrate at which clamping pressure can efficiently be applied to substrate 400. By reciprocate drive mechanism 131 moving press frame mechanism 130, the center position of substrate 400 and press center position 133 of press means 132 can be matched with each other.

The present embodiment shows the mechanism where molds 110 are fixed to machine frame 101. Therefore, press frame mechanism 130 reciprocates along machine frame 101 (see Fig. 1). It is noted that the relationship between them is relative. A configuration which is reverse of the configuration shown in the drawing, that is, the configuration where the position of press frame mechanism 130 is fixed and molds 110 reciprocate may be employed.

Further, it is necessary that press means 132 and mold 110 (in the illustrated example, mold mounting block 125) are separated in order to implement the above-described relative movement. It is noted that they (132, 125) may be fixed after the above-described center-alignment adjustment is finished. In this case, there is an advantage that, as the center-alignment adjustment is finished already, press means 132 can be used as a vertical drive mechanism for simultaneously mold-opening or clamping the two sets of mold structure units (molds 110) arranged as stacked, effectively using the movement of press means 132 in its vertical direction.

Pot block 140 is arranged beside molds 110, and provided so that it is freely joined and separated with respect to side position 110a of the mold intersecting perpendicularly with mold face (PL face) of mold 110 by reciprocate drive mechanism 150.

Pot block 140 is provided with a pot 141 for supplying a resin material arranged corresponding to the number of the vertical two sets of mold structure units (molds 110) and their arrangement position, a plunger 142 for pressurizing the resin material supplied inside pot 141, and a reciprocate drive mechanism 143 for causing plunger 142 to reciprocate.

To a side frames 102 arranged each side portion of pot block 140, a stopper mechanism 103 is arranged for more surely maintaining joined state when pot block 140 is joined with side position 110a of the mold intersecting perpendicularly with mold face (PL face) of mold 110. Stopper mechanism 103 is provided with a stopper member 104 joining with a back surface 140a of pot block 140 joined with mold 110, so as to press and stop back surface 140a against side position 110a of mold 110.

To pot block 140, an appropriate heater (not shown) for heating and melting resin material 301 supplied inside pot 141 is inserted.

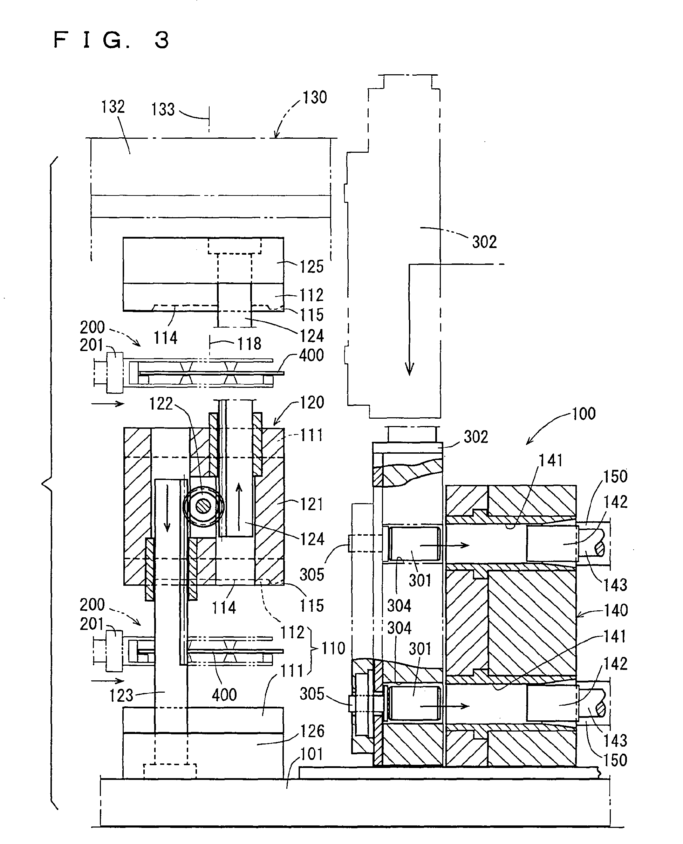

Therefore, according to this configuration, by one reciprocate drive mechanism 150, the whole pot block 140 can be advanced to be joined with the position where mold face of mold 110 and side position 110a intersect, and can be retracted to be separated from this position. Further, retracting plunger 142 by the other reciprocate mechanism 143, a space for supplying resin material 301 in a portion of pot 141 (see Fig. 3) can be formed. Advancing plunger 142 from this position, resin material 301 supplied to pot 141 can be pressurized.

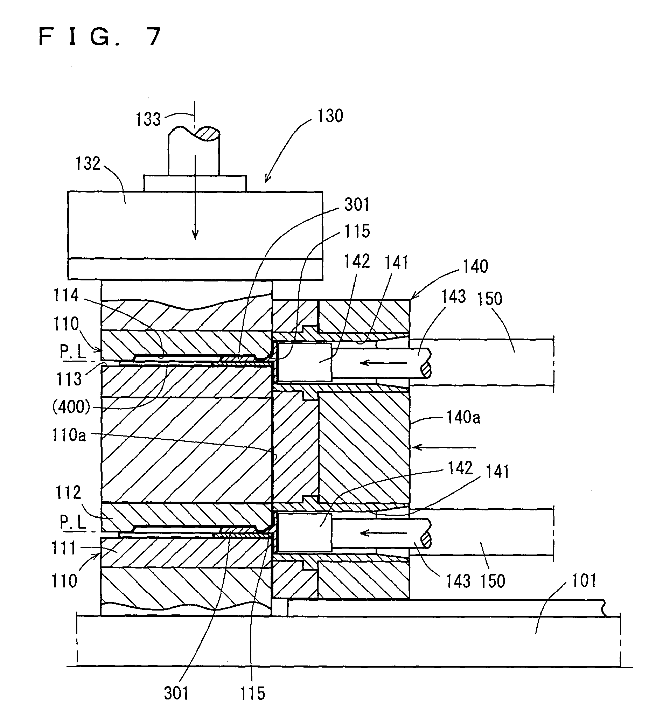

A space formed by first mold 111 and second mold 112 in the mold structure unit and pot 141 in pot block 140 with each other (see Figs. 7-9) can be communicated with each other. By heating and melting resin material 301 in pot 141 by the heater and pressurizing resin material 301 with plunger 142, through transfer path 115, the molten resin material in pot 141 can directly be injected so that cavity 114 is filled therewith.

Using a substrate supply-remove member 201 having an appropriate stop mechanism (not shown) such as a stop chuck, substrate supply-remove mechanism 200 can carry before-resin-seal-molding substrate 400 to a prescribed position in resin-seal-molding portion 100, that is, between first mold 111 and second mold 112 in each of the vertical two sets of mold structure units as mold-opened. Substrate supply-remove mechanism 200 can supply-set substrate 400 to substrate supply-set surface 113 of first mold 111. Further, substrate supply-remove mechanism 200 stops resin-seal-molded substrate 402 (resin-seal-molded product) using the stop mechanism and removes it from substrate supply-set surface 113 as mold-opened after resin-seal-molding. Substrate supply-remove mechanism 200 is provided so that it can carry substrate 402 to the outside from between first mold 111 and second mold 112 in each of the vertical two sets of mold structure units and transfer it to an apparatus where the next process is performed.

Therefore, according to this configuration, before-resin-seal-molding substrate 400 can be supply-set to a prescribed position in resin-seal-molding portion 100 and resin-seal-molded substrate 402 can be removed to the outside of resin-seal-molding portion 100.

Resin material carry-supply mechanism 300 is provided so that it can supply resin material 301 accommodated in a resin material accommodating portion 303 to a prescribed position in resin-seal-molding portion 100 using a resin material carry-supply member 302, that is, to a space provided to the opening-front end of pot 141 when pot block 140 and plunger 142 are retracted to a prescribed position (see Figs. 1-4).

Resin material carry-supply member 302 is provided with holes 304 for feeding the resin material arranged corresponding to the number of the vertical two sets of mold structure units (molds 110) and their arrangement position, and extrude members 305 for extruding resin material 301 fed in holes 304 to supply it into pot 141.

Therefore, according to this configuration, by retracting pot block 140 to a prescribed position, resin material 301 can be supplied to each pot 141 in pot block 140.

Resin-seal-molding of an electronic component in the above embodiment is carried out as follows, for example.

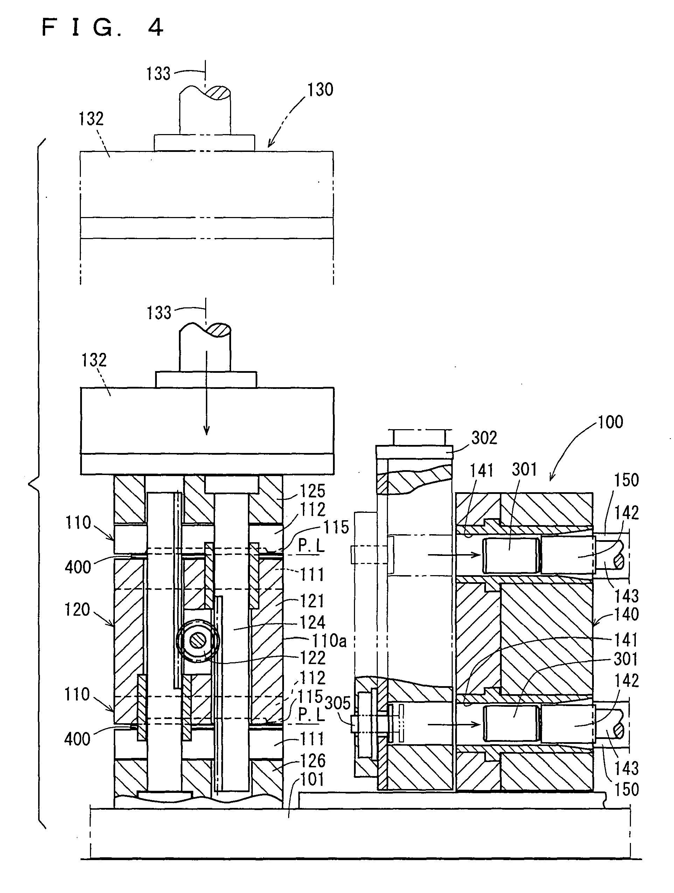

First, in the open-mold state of the vertical two sets of mold structure units (molds 110) shown in Figs. 1 and 3, substrate supply-remove mechanism 200 carries before-resin-seal-molding substrate 400 to between first mold 111 and second mold 112, and supply-sets substrate 400 to substrate supply-set surface 113 of first mold 111. As shown in Fig. 4, reciprocate drive mechanism 150 retracts the entire pot block 140 from the position of mold 110. Reciprocate drive mechanism 143 retracts plunger 142 to form a space for supplying resin material 301 in the opening-front end of pot 141.

Next, as shown in Fig. 4, mold open-close mechanism 120 clamps the vertical two sets of mold structure units (molds 110).

Next, reciprocate drive mechanism 131 performs alignment adjustment of moving press center position 133 of press means 132 in press frame mechanism 130 to a position where it matches with center position 118 of mold 110 (see Fig.1). Reciprocate drive mechanism 131 applies pressing force of press means 132 to center position 118 of clamped mold 110. Thus, reciprocate drive mechanism 131 applies clamping force of press means 132 to each of the mold structure units (molds 110) arranged as stacked simultaneously and uniformly (see Fig. 4). Resin material carry-supply member 302 supplies resin material 301 accommodated in a resin material accommodating portion 303 into the space of pot 141 (see Figs. 1, 3 and 4).

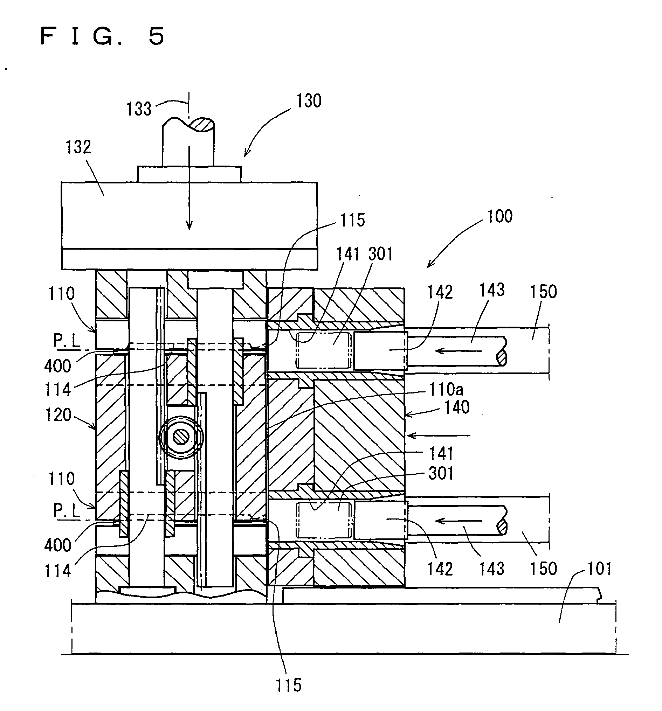

Next, as shown in Figs. 5-7, reciprocate drive mechanism 150 joins pot block 140 with side position 110a of the mold intersecting perpendicularly with mold face (PL face) of mold 110. Reciprocate drive mechanism 150 joins stopper member 104 in stopper mechanism 103 with back surface 140a of pot block 140, to stop back surface 140a against side position 110a of mold 110 in a state being pressed. Here, the mold face of first mold 111 and second mold 112 in the mold structure unit (mold 110) and pot 141 in pot block 140 communicate with each other, and resin material 301 supplied inside pot 141 is heated and melted by the heater.

Next, by advancing plunger 142 to pressurize resin material 301 (molten resin material) in pot 141, the material is directly injected into cavity 114 through transfer path 115 so that cavity 114 is filled therewith. Thus, the electronic component on substrate 400 inserted into cavity 114 can be resin-seal-molded.

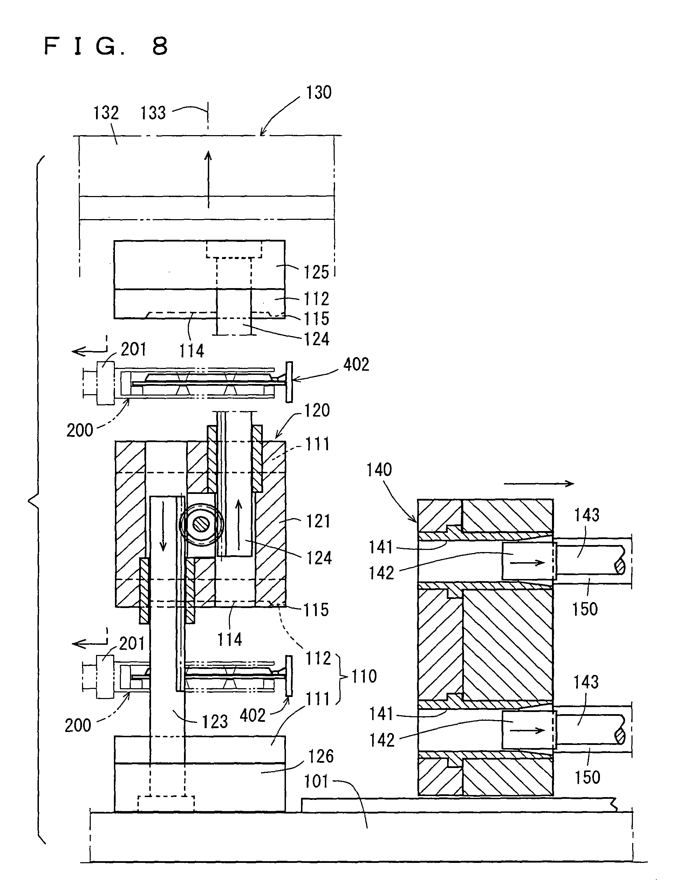

Next, after a prescribed cure time has elapsed, the stopping of pot block back surface 140a by stopper member 104 is released. As shown in Fig. 8, reciprocate drive mechanism 150 moves pot block 140 in a direction away from side position 110a of mold 110. Also, clamping to the vertical two sets of mold structure units (molds 110) by press means 132 of the press frame mechanism is released. Mold open-close mechanism 120 mold-opens the vertical two sets of mold structure units (molds 110).

Next, the stop mechanism of substrate supply-remove mechanism 200 stops resin-seal-molded substrate 402 (resin-seal-molded product) and removes substrate 402 from substrate supply-set surface 113 as mold-opened, and carries substrate 400 to outside and transfers it to a position of an apparatus where the next process is carried out.

As above, the apparatus for resin-seal-molding an electronic component shown in the present embodiment includes simply structured mold, and therefore the operability or workability thereof can be improved. This facilitates practical application of the apparatus.

Further, resin flash formation on the substrate surface can efficiently and surely be prevented without being affected by the variation in the thickness of a substrate. Therefore, a resin-seal-molded product of an electronic component of high quality and high reliability can be molded.

A simple structure can be employed for the resin-seal-molding apparatus. Therefore, the shape of the overall apparatus can be made small. Further, the maintenance works of the mold can be carried out easily. Still further, the wasted resin amount can be suppressed to thereby contribute to resource saving.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A method of resin-seal-molding an electronic component, comprising:
a mold-structure-unit-preparing step of preparing at least one mold structure unit (110) for resin-seal-molding an electronic component, said mold structure unit being provided to freely open and close;
a before-resin-seal-molding-substrate-supplying step of supplying a single before-resin-seal-molding substrate (400) having an electronic component mounted thereon between mold surfaces in said mold structure unit (110);
a clamping step of, when closing said mold surfaces to clamp, inserting the electronic component on said before-resin-seal-molding substrate and a prescribed surrounding portion into a molding cavity (114) provided between said mold surfaces, and applying in this state a prescribed clamping pressure from said mold surface to a surface of said substrate (400);
a resin-seal-molding step of, after said clamping step, filling said cavity (114) with a molten resin material (301) to seal by said molten resin material (301) the electronic component and the prescribed surrounding portion being inserted into said cavity (114), and to bring a resin-seal-molded body formed by cure of said resin material (301) and said substrate (400) into close contact with each other to be integrated; and
a resin-seal-molded-substrate-removing step of, after said resin-seal-molding step, opening said mold surfaces to remove the resin-seal-molded substrate (400).

2. The method of resin-seal-molding an electronic component according to claim 1, wherein
in said mold-structure-unit-preparing step, a plurality of said mold structure units (110) are arranged as stacked, and further, in said clamping step, the clamping pressure is simultaneously applied to each of the plurality of mold structure units (110) arranged as stacked.

3. An apparatus for resin-seal-molding an electronic component having each means for implementing the method of resin-seal-molding an electronic component according to claim 1.
